**Europäisches Patentamt**

**European Patent Office**

**Office européen des brevets**

(19)

(11) Veröffentlichungsnummer: **0 273 163**
**B1**

(12)

# EUROPÄISCHE PATENTSCHRIFT

(45) Veröffentlichungstag der Patentschrift:
08.08.90

(51) Int. Cl.⁵: **B60R 11/00, H05K 7/20**

(21) Anmeldenummer: **87116608.8**

(22) Anmeldetag: **10.11.87**

(54) Anordnung zur Halterung eines Gehäuses an einem Träger, insbesondere für Kraftfahrzeuge.

(30) Priorität: **28.11.86 DE 3640667**

(43) Veröffentlichungstag der Anmeldung:
**06.07.88 Patentblatt 88/27**

(45) Bekanntmachung des Hinweises auf die Patenterteilung:
**08.08.90 Patentblatt 90/32**

(84) Benannte Vertragsstaaten:
**DE ES FR GB IT SE**

(56) Entgegenhaltungen:
**DE-A- 2 942 936**
**FR-A- 1 507 288**
**US-A- 2 784 931**
**US-A- 4 157 583**

(73) Patentinhaber: **Siemens Aktiengesellschaft,
Wittelsbacherplatz 2, D-8000 München 2(DE)**

(72) Erfinder: **Deeken, Helmut, Dipl.-Ing. (FH), Im Reichen
Winkel 15, D-8400 Regensburg(DE)**

## Beschreibung

Die Erfindung betrifft eine Anordnung gemäß dem Oberbegriff von Anspruch 1.

In Kraftfahrzeugen werden in zunehmendem Maße elektronische Bausteine (Antiblockiersystem, Motorsteuerung, Schließanlage, Navigationssystem) eingesetzt, die jeweils in einem eigenem Gehäuse untergebracht sind, das an einem Träger in der Karosserie befestigt ist. Die Verbindung zwischen jedem Gehäuse und dem Träger muß dabei so gestaltet sein, daß sie hohen Anforderungen an die Betriebssicherheit gerecht wird und einen zuverlässigen Wärmeübergang zum Abführen der vom Baustein erzeugten Wärme gewährleistet.

Aus der DE-A 2 942 936 ist eine Anordnung dieser Art bekannt, bei der mindestens ein Gehäuse mit jeweils einer Schraubverbindung an dem Träger befestigt ist. Dadurch ist zwar ein ausreichender Wärmeübergang zwischen dem Gehäuse und Träger gegeben, aber zur Montage und Demontage eines Gehäuses ist relativ viel Platz notwendig und das Lösen und Befestigen der Schraubverbindung ist umständlich und zeitaufwendig.

Der Erfindung liegt die Aufgabe zugrunde, eine Anordnung der eingangs genannten Art so zu gestalten, daß eine einfachere Montage und Demontage des Gehäuses auch bei geringem Platzangebot möglich ist, ohne daß die vorgenannten Anforderungen an die Zuverlässigkeit der Befestigung und an den Wärmeübergang beeinträchtigt sind.

Die erfindugnsgemäße Lösung dieser Aufgabe ist in Anspruch 1 gekennzeichnet.

Demnach besteht die Führungseinrichtung aus einem Führungsteil an einer Lagerseite des Gehäuses und einer Führungsnut in der Lagerfläche des Trägers, in die das Führungsteil eingreift. Letzteres kann sehr schmal ausgelegt werden, so daß ein optimaler Wärmeübergang an der wirksamen Berührungsfläche zwischen Gehäuse und Träger gegeben ist. Das Führungsteil ist zugleich ein Teil der leicht lösbaren Spannvorrichtung, die außerdem eine Zugeinrichtung aufweist, die mit dem Führungsteil verbunden ist.

Die erfindungsgemäße Anordnung kann auch dann eingesetzt werden, wenn das Platzangebot derart eingeschränkt ist, daß die Anordnung nur von einer Seite zugänglich ist, die rechtwinklig zur Trägerebene liegt. Das kann z.B. bei dem beschränkten Platzangebot im Motorraum eines Kraftfahrzeuges ausgenützt werden. Die Erfindung ermöglicht es, mehrere Gehäuse aneinanderstoßend auf engem Raum am Träger unterzubringen, was durch die räumliche Anordnung von Spannvorrichtung und Führungseinrichtung bewirkt wird.

Die Zugeinrichtung der Spannvorrichtung besteht vorzugsweise aus einem Kipphebel und einem Verbindungsstück, das das Führungsteil mit dem Kipphebel verbindet.

Als Verbindungsstück kann z.B. ein Zugstab oder Zugriemen dienen. Virzugsweise ist eine einfache Zugfeder verwendet. Das Hebelgetriebe der Spannvorrichtung, bestehend aus Kipphebel, Zugfeder und Führungsteil, ermöglicht es eine relativ kleine äußere Kraft in eine sehr hohe Anpreßkraft zwischen dem Gehäuse und dem Träger umzusetzen. Die Anpreßkraft sollte größer als 300 Newton sein, um eine hohe Betriebssicherheit und einen optimalen Wärmeübergang zwischen Gehäuse und Träger zu realisieren. Vorzugsweise hat die Spannvorrichtung eine Vorspanneinrichtung, durch die sie mit ausreichender Stabilität am Gehäuse gehalten wird, wenn das Gehäuse nicht eingeschoben ist. Damit ist auch das Führungsteil ausreichend am Gehäuse fixiert, um diese beim Einschieben des Führungsteils in der Führungsnut sicher zu führen.

Eine exakte Führung ist von besonderer Bedeutung, wenn gemäß einer Weiterbildung der Erfindung zwischen Gehäuse und Träger eine herkömmliche Steckverbindung vorgesehen ist. Eine solche erleichtert zusätzlich den Austausch eines Bausteins durch einen Ersatzbaustein bei Wartungsarbeiten.

Eine weitere vorteilhafte Ausgestaltung besteht darin, daß das Führungsteil am Träger gelagert ist. Dafür hat es ein Lagerteil, mit dem es im Träger in einem Widerlager angeordnet ist.

Es können auch mehrere Führungsnuten nebeneinander im Träger angeordnet sein um eine entsprechende Anzahl von Gehäusen, auch mit unterschiedlicher Größe, daran befestigen zu können. Auf diese Weise können alle elektronischen Bausteine eines Fahrzeuges auf einem einzigen Träger an einer Stelle der Karosserie angeordnet werden. Daraus resultiert eine bessere Raumausnutzung und ein einfacherer Aufbau des Kabelbaums.

Weitere vorteilhafte Ausgestaltungen der Erfindung sind in den Unteransprüchen gekennzeichnet.

Die Erfindung wird im folgenden durch ein Ausführungsbeispiel näher erläutert. Es zeigen:

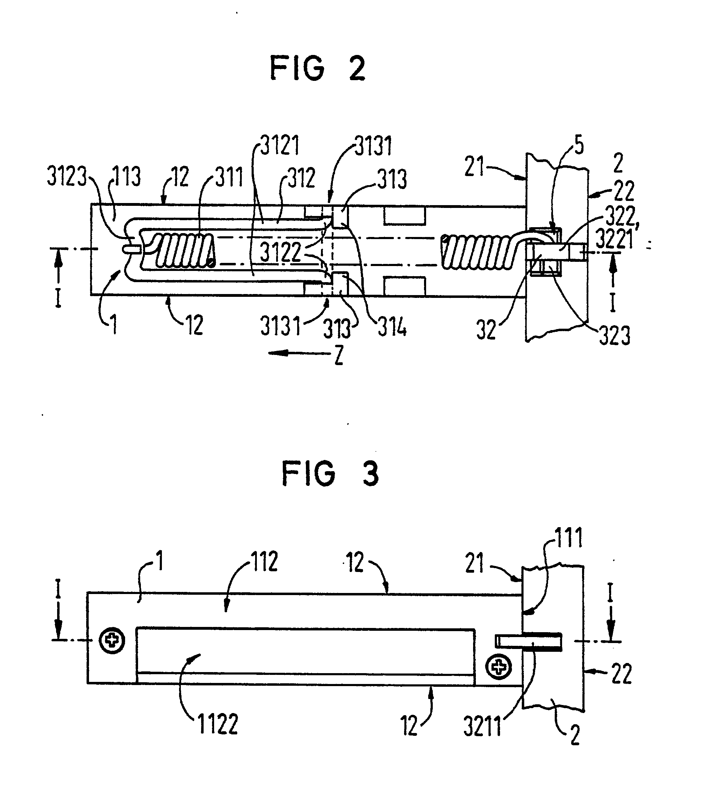

FIG 1 einen Schnitt durch eine Anordnung mit Träger und daran gehaltertem Gehäuse entlang der Linie I in FIG 2 und FIG 3,

FIG 2 eine Ansicht der Anordnung in Richtung des Pfeiles II in FIG 1,

FIG 3 eine Ansicht der Anordnung in Richtung des Pfeiles III in FIG 1 ohne Steckvorrichtung,

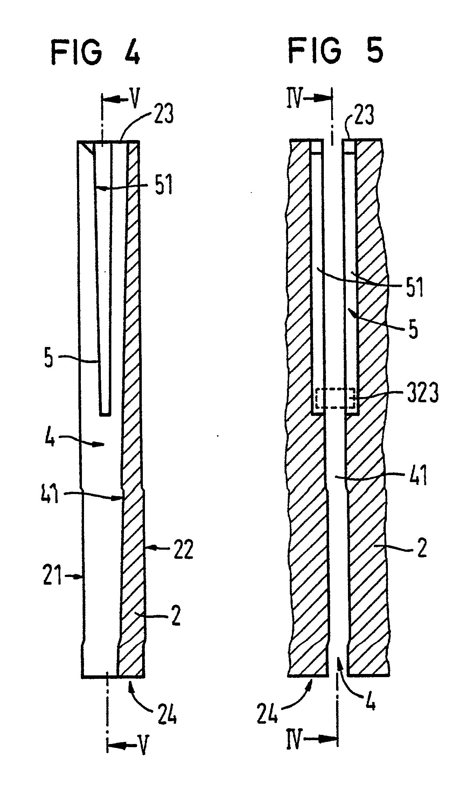

FIG 4 einen Schnitt durch den Träger längs der Linie IV in FIG 5, und

FIG 5 einen Schnitt durch den Träger mit Führungsnut und Lagernut entlang Linie V in FIG 1 und FIG 4.

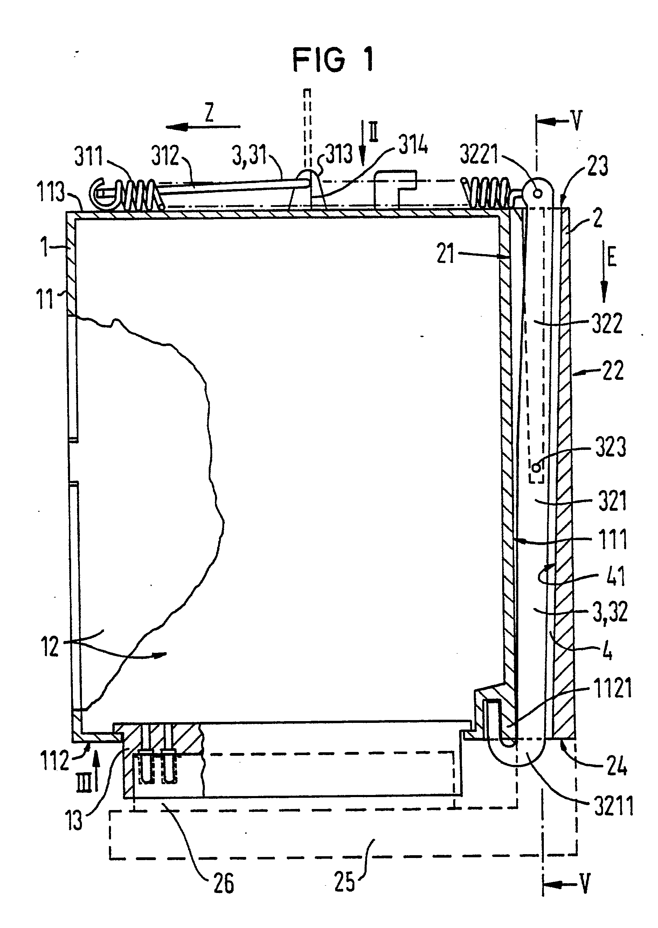

Das metallische Gehäuse 1 weist einen rechtwinkligen Rahmen II auf, der aus vier schmalen Wandteilen mit relativ geringer Wandstärke besteht. Am Rahmen 11 sind zwei gleichgroße rechteckige, ebene Deckelteile 12 befestigt, die zusammen mit dem Rahmen 11 das Gehäuse 1 bilden. Der Rahmen 11 hat außen eine Lagerseite 111 und rechtwinklig dazu eine Spannseite 113 und eine Anschlußseite 112. An der Anschlußseite 112 ist eine Steckeröffnung 1122 vorgesehen, in der eine Steckvorrichtung 13 mit mehreren Stiftreihen verschraubt ist. Benachbart zur Lagerseite III hat der Rahmen an Anschlußseite 112 ein Andruckteil 1121 (FIG 1).

Wärme erzeugende Bauteile sind in dem Gehäuse so angeordnet, daß ein möglichst guter Wärmeübergang zur Innenseite der Lagerseite 111 gegeben ist.

Der massive Träger 2 ist aus einem Material guter Wärmeleitfähigkeit, z.B. aus Aluminium gefertigt und hat eine Rückseite 22, mit der er z.B. an einem Karosserieteil eines Kraftfahrzeuges befestigbar ist.

Parallel zur Rückseite 22 hat der Träger 2 eine Lagerfläche 21, gegen die die Lagerseite 111 des Gehäuses 1 gepresst ist, wenn das Gehäuse 1 am Träger 2 in einer Spannlage verspannt ist (FIG 1). Als Teil einer Führungseinrichtung ist im Träger 2 eine Führungsnut 4 mit Boden 41 angeordnet, die von einer Frontseite 23 des Trägers 2 bis zu einer Hinterseite 24 des Träger 2 durchgehend verläuft. Die Führungsnut 4 ist zur Lagerfläche 21 hin offen. Die Tiefe der Führungsnut 4, die gleich der Distanz zwischen der Lagerfläche 21 des Trägers 2 und dem Boden 41 ist, nimmt von der Frontseite 23 des Trägers 2 bis zu seiner Hinterseite 24 geradlinig ab. Im Träger 2 verläuft eine Lagernut 5 die die Führungsnut 4 rechtwinklig kreuzt, an der Frontseite 23 des Trägers 2 beginnt und etwa bis zur Mitte der Lagerfläche 21 in den Träger 2 hineinreicht. Sie hat zwei schräge Keilflächen 51, deren Abstand von der Lagerfläche 21 gegen die Mitte des Trägers 2 zunimmt.

Die Lagernut dient als Widerlager für ein Lagerteil 323 einer Spannvorrichtung 3. Diese besteht aus einer Zugeinrichtung 31 und einem Führungsteil 32 aus Federstahl, das in der Führungsnut 4 am Träger 2 geführt und gelagert ist. Das Führungsteil 32 ist als zweiarmiger Hebel mit je einem Zugschenkel 321, 322 zu beiden Seiten des Lagerteils 323 ausgebildet und ragt zu beiden Seiten aus der Führungsnut 4. Das an der Spannseite 113 herausragende Ende des Zugschenkels 322 trägt ein Kupplungstück 3221, das Ende des anderen Zugschenkels 321 trägt einen U-förmigen Zughaken 3211, der das Andruckteil 1121 an der Anchlußseit 112 des Gehäuses 1 umgreift. Die Breite des Führungsteils 32 entspricht im wesentlichen der Breite der Führungsnut 4; die Höhe ist wesentlich größer als die Breite, um so eine hohe Biegesteifigkeit zu erreichen.

Das Lagerteil 323 ist stiftförmig und paßt in die Lagernut 5, wo es sich beim Spannen der Spannvorrichtung 3 gegen die Keilflächen 51 abstützt.

Die Zugeinrichtung 31 besteht aus einem Verbindungsstück in Form einer schraugenförmigen Zugfeder 311, einem Kipphebel 312 und einem Hebellager für den Kipphebel 312, das im Lagerstück 313 an der Spannseite 113 des Gehäuses 1 angeordnet ist.

Der Kipphebel 312 hat im wesentlichen U-förmige Gestalt und weist ein jochförmiges Verbindungteil 3123 zwischen zwei parallel veralufenden Schenkeln 3121 auf; letztere haben an ihren freien Enden rechtwinklig angeobgene, relativ kurze Lagerschenkel 3122, die zu den Deckelteilen 12 hin von den Schenkeln 3121 abstehen. Jedes der Lagerstücke 313 liegt benachbart zu einem Deckelteil 12 an der Spannseite 113 des Gehäuses 1 und hat eine Lagerbohrung 3131, in der ein Lagerschenkel 3122 drehbar gelagert ist. Die Lagerstücke 313 haben jeweils einen vorstehenden Anschlag 314, gegen den der Kipphebel 312 in einer Vorspannposition anschlägt (gestrichelt eingezeichnet).

Die Zugfeder 311 ist mit den Federenden zwischen dem Verbindungteil 3123 des Kipphebels 312 und dem Kupplungsstück 3221 am Zugschenkel 322 des Führungsteils 32 eingehängt.

Vor dem Zusammenbau von Träger 2 und Gehäuse 1 befindet sich die Spannvorrichtung 3 an dem Gehäuse 1 in der Vorspannposition: Dabei ist das Führungsteil 32 entlang der Lagerseite 111 des Gehäuses 1 angeordnet und umgreift mit dem Zughaken 3211 das Andruckteil 1121 am Gehäuse 1. Das Kupplungsstück 3221 am anderen Ende des Führungsteils 32 ist über die leicht gespannte Zugfeder 311 mit dm Kipphebel 312 verbunden. Dadurch wird das Führungsteil 32 gegen die Lagerseite 111 und der Kipphebel 312 gegen die Anschläge 314 gezogen und so die Spannvorrichtung 3 mit Führungsteil 32 am Gehäuse 1 gehalten.

Zum Verbinden von Gehäuse 1 und Träger 2 wird das Gehäuse 1 auf den Träger 2 so aufgestetzt, daß das Führungsteil 32 in die Führungsnut 4 und das Lagerteil 323 in die Lagernut 5 des Trägers eingreift.

Beim weiteren Verschieben des Gehäuses 1 in Richtung auf die in Figur 1 dargestellte Endposition - in Einschubrichtung E - gleitet das Lagerteil 323 an den Keilflächen 51 der Lagernut 5 entlang, bis das Gehäuse 1 seine Endposition gemäß FIG 1 eingenommen hat.

Beim Umlegen des Kepphebels 312 aus der in FIG 1 gestrichelt angedeuteten Vorspannposition in die gezeichnete Spannlage - in Spannrichtung Z - wird die Zugfeder 311 und das Führungsteil 32 gespannt. Letzteres bewegt sich dabei etwas entgegen dem Uhrzeigersinn um das Lagerteil 323 und zieht mit dem Zughaken 3211 das Gehäuse 1 auch an seinem anderen Ende gegen den Träger 2. Bei gleicher Länge der Zugschenkel 321, 322 sind dabei die Kräfte zwischen Gehäuse 1 und Träger 2 gleich. In der Spannlage greift die Zugfeder 311 so an dem Kipphebel 312 an, daß dieser gegen die Spannseite 113 des Gehäuses 1 gezogen wird, also in der Spannlage gesichert ist. Hierzu ist der Lagerpunkt des Kipphebels 312 mit solchem Abstand von der Spannseite 113 des Gehäuses 1 angeordnet, daß die Kraftlinie der Zugfeder 311 zwischen dem Lagerpunkt und der Spannseite 113 des Gehäuses 1 verläuft. Daher bewegt sich der Kipphebel 312 selbsttätig in die Spannlage, wenn er durch Einwirkung einer äußeren Kraft in Spannichtung Z über einen Umkippunkt gedreht wird. Umgekehrt bewegt sich der Kipphebel 312 selbstständig in die Vorspannposition, wenn er in Gegenrichtung über den Umkippunkt bewegt wird.

An der Hinterseite 24 des Trägers 2 kann ein Gegenstecker 26 über ein Befestigungsteil 25 angeordnet sein, dem die Steckvorrichtung 13 am Gehäuse 1 zugeordnet ist.

## Patentansprüche

1. Anordnung zur Halterung mindestens eines Gehäuses mit einer Lagerseite (111) an einem Träger (2), der als Kühlkörper wirkt und eine Lagerfläche (21) hat,
- mit einer Führungseinrichtung, durch die die Position des Gehäuses (1) am Träger (2) festgelegt ist, und
- mit einer Spannvorrichtung (3), durch die das Gehäuse (1) mit der Lagerseite (111) gegen die Lagerfläche (21) des Trägers (2) verspannt ist,
dadurch gekennzeichnet,
- daß als Führungseinrichtung eine Führungsnut (4) in der Lagerfläche (21) des Trägers (2) in Verbindung mit einem Führungsteil (32) an der Lagerseite (111) dient, das in die Führungsnut (4) eingreift, und
- daß die Spannvorrichtung (3) an einer Seite des Gehäuses angeordnet ist, die rechtwinklig zu der Lagerseite (111) verläuft, und aus dem Führungsteil (32) und einer Zugeinrichtung (31) besteht, die mit dem Führungsteil (32) verbunden ist.

2. Anordnung nach Anspruch 1,
dadurch gekennzeichnet,
- daß das Führungsteil (32) als zweiarmiger Hebel mit je einem Zugschenkel (321, 322) zu beiden Seiten eines Lagerteiles (323) ausgebildet ist,
- daß quer zur Führungsnut (4) im Träger (2) ein Widerlager für das Lagerteil (323) angeordnet ist,
- daß sich an dem freien Ende des eines Zugschenkels (321) ein Zughaken (3211) und am Ende des anderen Zugschenkels (322) ein Kupplungsstück (3221) befindet,
- daß der Zughaken (3211) ein Andruckteil (1121) des Gehäuses (1) übergreift, und
- daß die Zugeinrichtung (31) einen Kipphebel (312) aufweist, der gelenkig über ein Verbindungsstück mit dem Kupplungsstück (3221) verbunden und an dem Gehäuse (1) so gelagert ist, daß er durch die Spannkraft der Spannvorrichtung (3) in einer Spannlage gehalten ist.

3. Anordung nach Anspruch 2,
dadurch gekennzeichnet,
daß das Verbindungsstück eine Zugfeder (311) ist.

4. Anordnung nach Anspruch 3,
dadurch gekennzeichnet,
daß der Kipphebel (312) durch einen Anschlag (314) in einer Vorspannposition blockiert ist, in der er und das Führungsteil (32) durch die Zugfeder (311) mit geringer Kraft gegeneinander verspannt und dadurch an dem Gehäuse (1) gehalten sind.

5. Anordnung nach Anspruch 4,
dadurch gekennzeichnet,
daß mehrere Führungsnuten (4) parallel zueinander im Träger (2) verlaufen.

6. Anordnung nach Anspruch 5,
dadurch gekennzeichnet,
daß an dem Träger (2) mindestens zwei Gehäuse (1) mit jeweils gleicher Führungseinrichtung und Spannvorrichtung (3) befestigt sind.

7. Anordnung nach Anspruch 5 oder Anspruch 6,
dadurch gekennzeichnet,
daß jedes Gehäuse (1) eine Steckvorrichtung (13) zum Anschluß an einen Gegenstecker (26) hat.

8. Anordnung nach Anspruch 7,
dadurch gekennzeichnet,
daß der Gegenstecker (26) am Träger (2) befestigt ist.

## Claims

1. Arrangement for mounting at least one housing having a bearing side (11) to a carrier (2) which acts as a cooling member and has a bearing surface (21), having a guide means with which the position of the housing (1) at the carrier (2) is determined and having a clamping mechanism (3) with which the housing (1) is clamped with its bearing side (111) against the bearing surface (21) of the carrier (2), characterized in that a guide channel (4) in the bearing surface (21) of the carrier (2) serves as guide device in combination with a guide part (32) at the bearing side (111), said guide part engaging in the guide channel (4), and in that the clamping mechanism (3) is arranged at a side of the housing which extends at a right angle relative to the bearing side (111) and consists of the guide part (32) and of a tension device (31) which is connected to the guide part (32).

2. Arrangement according to Claim 1, characterized in taht the guide part (32) is constructed as a two-armed lever having in each case one tension leg (321, 322) on each side of a bearing part (323), in that an abutment for the bearing part (323) is arranged transversely to the guide channel (4) in the carrier (2), in that a tension hook (3211) is situated at the free end of the one tension leg (321) and a coupling member (3221) is situated at the end of the other tension leg (322), in that the tension hook (3211) overlaps a pressing part (1121) of the housing (1), and in that the tension devtice (31) has a rocking lever (312) which is connected in an articulated manner to the coupling piece (3221) via a connector piece and is mounted at the housing (1) in such a way that it is held in a clamped position by the clamping force of the clamping mechanism (3).

3. Arrangement according to Claim 2, characterized in that the connector piece is a tension spring (311).

4. Arrangement according to Claim 3, characterized in hat the rocking lever (312) is blocked in a prestressing position by a dog (314), the rocking lever and the guide part (32) being tensed relative to one another with slight force by the tension spring (311) and being thereby held against the housing (1).

5. Arrangement according to Claim 4, characterized in hat a plurality of guide channels (4) extend parallel to one another in the carrier (2).

6. Arrangement according to Claim 5, characterized in hat at least two housings (1) having in each case an identical guide device and clamping mechanism (3) are secured to the carrier (2).

7. Arrangement according to Claim 5 or Claim 6, characterized in that every housing (1) has a plug-in mechanism (13) for connection to a mating connector (26).

8. Arrangement according to Claim 7, characterized in that the mating connector (26) is secured to the carrier (2).

## Revendications

1. Dispositif de fixation d'au moins un boîtier, ayant un côté d'appui (111), à un support (2), qui sert de corps de refroidissement et qui présente une surface d'appui (21), comprenant :
- un dispositif de guidage qui détermine la position du boîtier (1) contre le support (2); et
- un dispositif de blocage (3) par lequel le boîtier (1) est bloqué par le côté d'appui (111) contre la surface d'appui (21) du support (2), caractérisé en ce que

– une gorge de guidage (4), ménagée dans la surface d'appui (21) du support, sert, en liaison avec une pièce de guidage (32) appliquée sur le côté d'appui (111) et pénétrant dans la gorge de guidage (4), de dispositif de guidage, et

– le dispositif de blocage (3) est disposé sur un côté du boîtier, qui s'étend perpendiculairement au côté d'appui (111), et est constitué d'une pièce de guidage (32) et d'un dispositif de traction (31) relié à la pièce de guidage (32).

2. Dispositif suivant la revendication 1, caractérisé en ce que

– la pièce de guidage (32) est constituée en levier à deux bras ayant des branches de traction (321, 322) des deux côtés d'une pièce de palier (323),

– une butée pour la pièce de butée (323) est disposée transversalement dans la gorge de guidage (4) du support (2),

– un crochet de traction (3211) se trouve à l'extrémité libre de l'une des branches de traction (321) et une pièce d'accouplement (3221) se trouve a l'extrémité de l'autre branche de traction (322),

– le crochet de traction (3211) s'accroche sur une partie d'application (1121) du boîtier (1), et

– le dispositif de traction (31) comporte un levier basculant (312) qui est articulé par une pièce de liaison à la pièce d'accouplement (3221) et qui est monté sur le boîtier (1) de manière à être maintenu par la force de blocage du dispositif de blocage (3), en une position de blocage.

3. Dispositif suivant la revendication 2, caractérisé en ce que, la pièce de liaison est un ressort de traction (311).

4. Dispositif suivant la revendication 3, caractérisé en ce que, le levier basculant (312) est bloqué par une butée (314) en une position de pré-blocage, dans laquelle le levier basculant et la pièce de guidage (32) sont bloqués l'un contre l'autre avec une faible force par le ressort de traction (311) et sont ainsi maintenus sur le boîtier (1).

5. Dispositif suivant la revendication 4, caractérisé en ce que, plusieurs gorges de guidage (4) s'étendent parallèlement les unes aux autres dans le support (2).

6. Dispositif suivant la revendication 5, caractérisé en ce que, sur le support (2) sont fixés au moins deux boîtiers (1) ayant respectivement le même dispositif de guidage et le même dispositif de blocage (3).

7. Dispositif suivant la revendication 5 ou la revendication 6, caractérisé en ce que, chaque boîtier (1) possède un dispositif destiné à être enfiché (13) pour le raccordement à un connecteur antagoniste (26).

8. Dispositif suivant la revendication 7, caractérisé en ce que, le connecteur antagoniste (26) est fixé au support (2).

# FIG 1

## FIG 2

## FIG 3

EP 0 273 163 B1

FIG 4

FIG 5